# EUROPEAN PATENT SPECIFICATION

(11) **EP 3 368 834 B1**
(45) Date of publication and mention of the grant of the patent: **07.08.2019**
(21) Application number: 16794431.3
(22) Date of filing: 28.10.2016
(51) Int. Cl.: C23C 14/34, C23C 14/06, C23C 14/08, C23C 14/10, F24S 70/20, F24S 70/30

(54) **METHOD FOR THE DEPOSITION OF FUNCTIONAL LAYERS SUITABLE FOR HEAT RECEIVER TUBES**
VERFAHREN ZUM ANORDNEN VON FUNKTIONSSCHICHTEN FÜR WÄRMEEMPFÄNGERROHRE
PROCÉDÉ POUR AGENCER DES COUCHES FONCTIONNELLES CONVENANT POUR DES TUBES RÉCEPTEURS THERMIQUES

(30) Priority: 30.10.2015 EP 15192258
(43) Date of publication of application: 05.09.2018
(73) Proprietor: Rioglass Solar Systems Ltd., 9905303 Beit Shemesh (IL)
(72) Inventor: BARKAI, Menashe, 69440 Tel Aviv (IL)
(74) Representative: ABG Intellectual Property, S.L.
(86) International application number: PCT/IB2016/056504
(87) International publication number: WO 2017/072711

(56) References cited:
- EP-A1- 2 341 038
- WO-A1-97/00335
- WO-A1-2012/065648
- WO-A1-2014/166803
- US-A1- 2005 136 691
- US-A1- 2013 342 900

## Description

### FIELD OF THE INVENTION

This invention relates to a method for arranging (i.e. depositing) at least one functional layer suitable for a multilayer solar selective coating. In particular, the method disclosed may be used to prepare functional coatings based on dielectric materials or on an arrangement of dielectric and conductive layers.

The functional coatings can be applied in the field of solar concentration technology for producing electric power from solar radiation, and more particularly, to heat receiver tubes in parabolic-trough power plants.

### BACKGROUND OF THE INVENTION

A sun energy collecting unit of a sun field power plant based on the concentrated solar power technique comprises, for instance, a trough with parabolic mirrors and a heat receiver tube. The heat receiver tube (also commonly known as heat collector element (HCE)) is arranged in a focal line of the mirrors. The sunlight is focused by the mirrors to the heat receiver tube, which is filled with a heat transfer fluid, e.g. a thermo-oil or a melted-thermo salt. The energy of the sunlight is coupled into the heat transfer fluid via the heat receiver tube to convert the solar energy to thermal energy.

In order to optimize the efficiency with which the energy of the sunlight is coupled into the heat transfer fluid, the receiver tube must be able to withstand high temperatures, maximize the absorption of solar radiation and, at the same time, minimize the energy loss of the radiation emission due to the high temperature.

For this purpose, the heat receiver tube is normally covered with a solar selective coating which provides the heat receiver tube with a high absorbance of the solar radiation, and a low emissivity with the range of infrared thermal radiation. Ideally, the coating should provide a 100% absorbance (α=1, reflectance 0%) within the solar irradiance range, and 0% emissivity (ε=0, reflectance 100%) within the thermal emittance range.

The solar selective coating commonly comprises a multilayer stack with sequentially deposited thin film layers (functional layers) having different optical characteristics which together provide the desired requisites of high absorption in the region of the solar spectrum, and high transparency in the region of the thermal infrared. For instance, these functional layers may be cermet layers and dielectric layers.

Cermet is an acronym derived from the words ceramic and metal, which are two major phases of this material. Cermet-type materials are ceramic-metal composite materials made up of a ceramic matrix and a metal, or a substance having a metallic behavior, dispersed in the ceramic matrix. The metal or metallic substance is present generally in the form of nanoparticles, which are typically of very small sizes, of the order of 10 - 50 Angstrom (1-5 nm). Another configuration is a multilayer stack of alternating thin layers of metal and dielectric. The ratio between metal to dielectric within the composite material is given by the filling factor (F.F.). The extinction coefficient, and in turn the absorbance, increases with the filing factor.

Cermet materials as solar absorbers have attracted interest since 1950s, when Tabor, Gier and Dunkle presented their first results on the use of cermets as coating materials for selective absorption of solar radiation. Since then, the selective characteristics of absorption of numerous composite materials have been studied.

Dielectric layers in the solar selective coating function as anti-reflective coating (AR) to match destructive interference over most of the solar spectrum and also as diffusion barriers, to restrict diffusion between the substrate and the coating and/or between the different layers.

There are numerous methods for depositing the different layers of the solar selective coating on the substrate surface, however in industrial practice the most convenient and efficient method is by sputtering. Sputter deposition or sputtering is a physical vapor deposition (PVD) method that involves ejecting material from a target onto a substrate by the bombardment of the target with energetic particles. Metals and dielectrics targets are used in the sputtering process. In particular, DC (Direct Current) Power supply is normally used for depositing metals, whereas RF (Radio Frequency) Power supply is used for depositing dielectric materials.

WO 97/00335A1 discloses a method to obtain a solar energy selective coating having a three-layer structure which comprises: an infrared reflective metal layer, a solar energy absorptive layer and anti-reflective layer. The absorptive coating is deposited as a cermet, typically a tungsten-aluminium nitride cermet, which is formed by sputtering material simultaneously from first and second metal electrodes in the presence of a gas which is reactive with the metal from which the second electrode is formed and substantially non-reactive with the metal from which the first electrode is formed.

In reactive sputtering, the deposited film is formed by sputtering of a metallic target in the presence of a reactive gas. The metallic ions from the metallic target react with the reactive gas to form the desired compound at the substrate. The composition of the film can be controlled by varying the relative pressures of inert and reactive gases.

A typical reactive sputtering process may operate in three different modes: metallic mode, compound mode and transition mode.

In the metallic mode, the reactive gas that flows into the chamber is not enough to react with all the sputtered material deposited. Thereby, the deposited film at the substrate is sub-stoichiometric. The sputtering target surface in this mode is predominantly metallic.

In the transition mode, there is a complex dependence of the composition on the reactive gas flow. The optimum conditions may be unstable.

In the compound mode, the reactive gas partial pressure is high and a compound film is not only formed on the substrate as desired, but also on the sputter target. The performance of reactive sputtering is, however, impeded by the effect of target "poisoning", resulting in a significantly reduced sputter yield and, thereby, a reduced deposition rate.

Compound films such as oxides or nitride films are often deposited using an insulating compound target via RF magnetron sputtering, or by reactive RF or MF magnetron sputtering from a conductive target under reactive gases.

Thus, when preparing cermet materials, the ceramic matrix is usually deposited by means of RF sputtering, or by means of reactive sputtering in an environment comprising reactive gases (O₂ or N₂), while the metal dispersed in the ceramic matrix is deposited by means of DC sputtering (DC-RF co-sputtering or DC-reactive co-sputtering as global process).

However, the use of RF power supply, as source for sputtering of dielectrics to form cermet or Anti-Reflective (AR) layers, presents some disadvantages and limitations like the following:
- low deposition rate of dielectrics and limited power supply level (up to 30 kW compared to more than 250 kW for DC sputtering) resulting in a low productivity; and
- low thickness uniformity.

Regarding the use of reactive MF sputtering for the deposition of dielectrics, trouble shootings are found such as non-uniformity of the thickness when operated in transition mode, or limited life of the target when operated in compound mode. Particularly, when a heat receiver tube is coated by reactive MF sputtering in the solar technical field, the major limitations are as follows:
- poor temperature durability in metallic mode, and
- low uniformity of the oxidation level.

Therefore, there is a need in the art for alternative methods for producing functional layers or coatings for multilayer solar selective coatings.

### BRIEF DESCRIPTION OF THE INVENTION

The present invention provides a method for arranging on a substrate functional layers suitable for multilayer solar selective coatings, and more specifically, for coatings of heat receiver tubes. In particular, this method is suitable for preparing coatings made up of different kinds of arrangements based on conductive and dielectric layers as well as coatings of dielectrics.

The coating method disclosed in the present application represents a versatile tool, giving practical and feasible implementation to a variety of deposition techniques, especially to DC and/or MF sputtering technology, for the achievement of uniform, reproducible and durable selective coatings to be used in solar technology.

Thus, in a first aspect the invention relates to a method for the deposition of at least one functional layer suitable for a multilayer solar selective coating, said method comprising:
a) providing a substrate;
b) depositing conductive material on said substrate in a deposition chamber (1) to obtain a substrate coated with at least one conductive layer;
c) transferring the coated substrate obtained in b) to a transformation chamber (2);
d) transforming the coating of the substrate by introducing a reactive gas into the transformation chamber (2) so that at least an outer conductive layer of the at least one conductive layer is partially or totally transformed into at least one dielectric layer;
   and
e) optionally, transferring the substrate obtained in d) to the deposition chamber (1) and repeating the method from step b) for a number of times.

The method of the invention may be referred to as "dual mode method" since it combines a step of depositing a conductive layer and a step of transforming, partially or totally, said conductive layer into a dielectric layer.

The method may be repeated as many times as necessary so as to obtain at least one functional layer.

In a preferred embodiment, the method is used to prepare coatings based on conductive and dielectric layers. More preferably, the method is used to prepare a periodic and alternate arrangement or stack of a conductive layer and a dielectric layer. Such multilayer arrangement or stack may exhibit an optical behaviour similar to a cermet material and it is herein referred to as cermet-like material.

In another preferred embodiment, the method is used to prepare coatings of dielectric materials, like oxides or nitrides.

Both types of functional layers, the coating of cermet-like material and the coating of dielectrics, may form part of a multilayer solar selective coating such as those designed for heat receiver tubes, i.e. absorbing layers, anti-reflective layers and diffusion barriers.

These and other aspects of the invention will be apparent from, and elucidated with reference to the embodiments described hereinafter.

### BRIEF DESCRIPTION OF THE FIGURES

To better understand the invention, its objects and advantages, the following figures are attached to the specification in which the following is depicted:

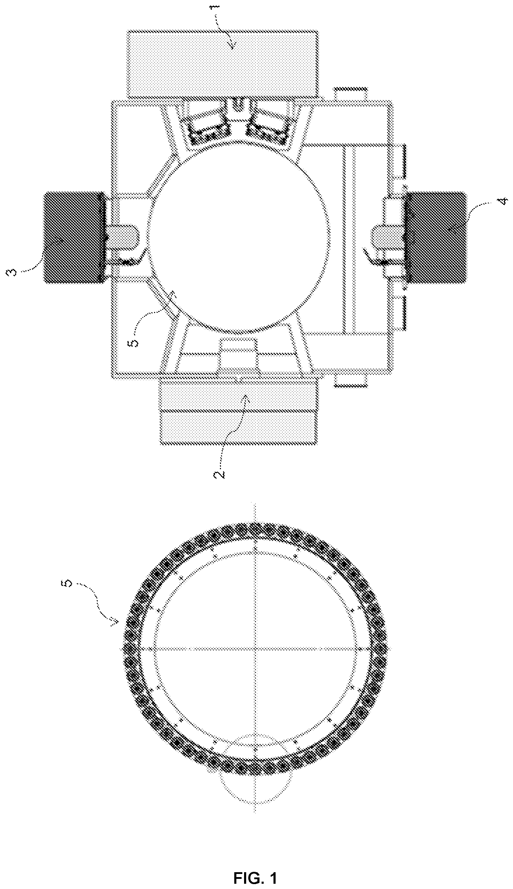

Figure 1 shows a cross section of an exemplary apparatus to carry out the method of the invention over heat receiver tubes. The apparatus is equipped with a deposition chamber (1) and a transformation chamber (2) and two separation chambers (3, 4) that are provided with vacuum pumps and placed between said chambers (1, 2). Besides there is a rotating carousel drum (5) wherein the tubes to be coated are loaded onto.

Each tube rotates at its axis during carousel rotation. Therefore, each tube moves like a planet, having both revolution and rotation.

### DETAILED DESCRIPTION OF THE INVENTION

The present invention provides a method for arranging functional layers as those used in multilayer solar selective coatings. The method of the invention is particularly useful for preparing a multi-stack of conductive and dielectric layers onto a substrate, as well as for the deposition of dielectric layers. The method of the invention comprises the following steps:
a) providing a substrate;
b) depositing conductive material on said substrate in a deposition chamber (1) to obtain a substrate coated with at least one conductive layer;
c) transferring the coated substrate obtained in b) to a transformation chamber (2);
d) transforming the surface of coated substrate by introducing a reactive gas into the transformation chamber (2) so that at least an outer conductive layer of the at least one conductive layer is partially or totally transformed into at least one dielectric layer; and
e) optionally, transferring the substrate obtained in d) to the deposition chamber (1) and repeating the method from step b) for as many times as necessary so as to obtain at least one functional layer.

As used herein, "functional layer or coating" refers to a layer or coating having a function, and the function means an action attained through physical and/or chemical phenomena, preferably said action being related to the optical characteristics. In a preferred embodiment, the functional layer is a cermet-like coating based on a periodic and alternate stack of conductive and dielectric layers sequentially deposited, which may be used as solar absorber to provide high solar absorption. In another preferred embodiment, the functional layer is a coating of dielectric material (such as an oxide or a nitride) which may be used as anti-reflective layer or as a diffusion barrier.

Adjacent layers cover each other at least partially. Preferably, a layer covers the subjacent layer completely.

In the context of the invention the term "substrate" refers to any material having at least a residual conductivity and comprising a surface that may be coated. Preferably, the substrates to be coated are selected from metal, oxides or ceramics. More preferably, the substrate is a heat receiver tube of stainless steel, which may be uncoated or coated with at least a previous coating.

According to step b) of the method of invention, a conductive material is deposited on the provided substrate in the deposition chamber (1) to obtain a substrate coated with at least one conductive layer. This conductive layer could be a metal, a semiconductor or a conductive ceramic such as borides.

Suitable techniques for the deposition of the conductive material in step b) include, but are not limited to, DC sputtering, MF pulsed DC sputtering or dual MF sputtering.

In the context of the present invention, the term "deposition chamber" or "attaching chamber" refers to a chamber in which a conductive layer is deposited. In a particular embodiment, the deposition chamber comprises a DC sputtering, a MF pulsed DC sputtering or a dual MF sputtering having at least a cathode loaded with a conductive target. In a more particular embodiment, the sputtering of the deposition chamber contains two cathodes each one loaded with a conductive target, which may be the same or different. In a more particular embodiment, one conductive layer is attached to the substrate. In another more particular embodiment, two different conductive layers are attached to the substrate by using two different cathodes, for instance in the DC sputtering.

In a particular embodiment, the material of the conductive target of the cathode contained in the sputtering is selected from the group including, but not limited to, aluminum (Al), chrome (Cr), titanium (Ti), niobium (Nb), zirconium (Zr), tantalum (Ta), nickel (Ni), copper (Cu), cobalt (Co), hafnium (Hf), vanadium (V), molybdenum (Mo), tungsten (W), Silicon (Si), Nichrome (NiCr), Titaniumboride (TiB₂), Tantalumboride (TaB₂), Zirconiumboride (ZrB₂), Hafiniumboride (HfB₂), Niobiumboride (NbB₂) and Vanadiumboride (VB₂) or a combination or alloy thereof. In a preferred embodiment, the conductive material is selected form a conductive ceramic such as a boride. Preferably, the conductive target is selected from the group consisting of Titaniumboride (TiB₂), Tantalumboride (TaB₂), Zirconiumboride (ZrB₂), Hafiniumboride (HfB₂), Niobiumboride (NbB₂) and Vanadiumboride (VB₂) or a combination or alloy thereof.

In other preferred embodiment, the conductive material is selected from Al, Si, Ti, Zr, Hf, V, Nb, Ta, Cu, Cr, Ni or a combination or alloy thereof.

In DC sputtering, a direct current (DC) is supplied to a cathode having a conductive target. The sputter voltage is typically comprised between about -300 V to about -1 kV. According to a particular embodiment, the voltage is comprised between about -300 V to -700 V.

In a particular embodiment, the DC sputtering is a DC magnetron sputtering further including magnets placed behind the target to increase the film deposition rate.

The DC sputtering of the deposition chamber normally includes a gas feed system for feeding any one of or any combination of inert gases such as argon and neon. Further, a control means is preferably provided for varying the working pressure, and for varying the flow of the inert gases in the attaching chamber. In particular, valves may control the flow of the gases to the cathode.

In the context of the present invention by the term "working pressure" is understood the pressure under which the deposition process takes place. The deposition or attaching of the conductive layer on the substrate by DC sputtering is conveniently performed in the presence of at least an inert gas such as argon. The working pressure during the deposition is typically comprised between about 1x10⁻³ mbar and about 5x10⁻³ mbar. In a particular embodiment, the working pressure is about 2x10⁻³ mbar to about 3x10⁻³ mbar of Ar.

In a particular embodiment, the substrate is annealed in the deposition chamber at a temperature comprised between about 200 °C and about 450 °C, preferably at a temperature comprised between about 220 °C and about 300 °C.

The distance between the substrate and the cathode is usually fixed. In a particular embodiment, the distance between the substrate and the cathode is comprised between about 3 mm and about 10 mm, preferably the distance is comprised between about 5 mm and about 8 mm. In a preferred embodiment, the distance between the substrate and the cathode is about 8 mm.

According to step c) of the method of the invention, the coated substrate obtained in b) is transferred to a transformation chamber.

In a particular embodiment, the coated substrate that is transferred to the transforming chamber is a coated heat receiver tube, said tube being loaded in a rotating carousel drum (5), wherein the rotating carousel drum periodically rotates among the deposition chamber (1) and the transformation chamber (2), while the loaded tubes rotate in turn around their own axis in planetary rotation. According to a particular configuration, the carousel drum (5) can load up to 56 tubes (e.g. 8, 16, 24, 32, 40, 48 or 56 tubes). In a particular embodiment, the deposition chamber (1) in the method of the invention is disposed next to the transformation chamber (2).

In another particular embodiment, the deposition chamber (1) and the transformation chamber (2) are separated with shields.

In a particular embodiment, there are separation chambers placed between the deposition chamber (1) and the transformation chamber (2). In a more particular embodiment, there is a separation chamber (3) placed between the deposition chamber (1) and the transformation chamber (2) and another separation chamber (4) placed between the transformation chamber (2) and the deposition chamber (1). The separation chambers may include one or more vacuum pumps.

In other particular embodiment, the atmosphere of the deposition and the transformation chamber is isolated by means of vacuum pumps connected to each one of the chambers.

The vacuum pumps may be selected for instance from rotary pump, turbo pump and a combination of both. The vacuum pressure achieved by the vacuum pumps is generally below 1x10⁻⁵ mbar and is normally comprised between about 1x10⁻³ mBar to about 5x10⁻³ mBar during the sputtering process.

In the context of the present invention, the term "transformation chamber" or "transforming chamber" refers to a chamber that includes a gas feed system for feeding reactive gases such as oxygen, nitrogen and combinations thereof. In a particular embodiment the transforming chamber contains oxygen or nitrogen as reactive gases. Besides, the gas feed system of the transforming chamber normally serves for feeding also inert gases such as argon, neon, and combinations thereof.

Further, a process control system is preferably provided for varying the ratio of inert gas to reactive gas via flow control valves. These valves may control the flow of the gas to the respectively associated cathode.

According to step d), the substrate coated with at least a conductive layer (e.g. a metallic or a boride layer) and transferred to the transforming chamber, is transformed so that at least the outer conductive layer is partially or totally transformed into at least one dielectric layer. When the substrate coated with at least a conductive layer obtained in step b) is transferred to a transforming chamber containing at least a reactive gas, the previously deposited conductive layer may totally or partially react with the introduced reactive gases to form a dielectric material, that is, the transformation of the conductive layer to a dielectric can be at any percentage of the conductive layer thickness. For instance, the outer conductive layer can be transformed into a dielectric about 10%, about 20%, about 30%, about 40%, about 50%, about 60%, about 70%, about 80%, about 90% deep from the surface or 100% (i.e. full transformation). In a particular embodiment, the outer conductive layer is totally transformed into a dielectric layer in step d) of the method of the invention.

In another particular embodiment, the substrate is coated with one conductive layer in step b) and said conductive layer is partial or totally transformed into a dielectric layer in step d). In another particular embodiment, the substrate is coated with two conductive layers in step b) and said conductive layers are partial or totally transformed into dielectric layers in step d).

In a particular embodiment, the working pressure in the transforming chamber is typically comprised between about 1x10⁻³ mBar to about 5x10⁻³ mBar. In a more particular embodiment the working pressure is comprised between about 2x10⁻³ mbar and about 3x10⁻³ mbar Ar.

Step d) may be assisted with a plasma discharge, as explained below.

Further, step d) may also comprise, after or simultaneously with the transformation of the conductive layer into dielectrics, the deposition of additional dielectric material by means of dual MF sputtering or pulsed DC sputtering. Preferably, said dielectric material is also deposited inside the transforming chamber.

The deposition of the additional dielectric material in step d) may be carried out by means of a MF sputtering or pulsed DC sputtering. In a particular embodiment, MF Dual Magnetron Sputtering is applied.

The MF Dual Magnetron Sputtering operates in Mid Frequency, e.g. from about 20 to about 350 kHz, and the sputter voltage is typically comprised between about -300 V to about -1 kV, preferably a voltage comprised between about -300 V to -700 V for depositing compounds. In this frequency range, the periodic target voltage reversals suppress arc formation at the target, providing stability to the process, particularly during the dielectrics deposition.

In a particular embodiment, the transforming chamber comprises a plasma source, so that step d) (i.e. transformation of conductive layer into dielectric layer and optionally deposition of additional dielectric material) is assisted with a plasma discharge. The plasma source produces a plasma discharge that improves the ionization of the reactive species. Preferably, the plasma source in the dual sputtering magnetron of the invention is mid frequency plasma with a frequency comprised between about 20 to about 100 kHz.

Plasma assistance is in particular useful in the formation of nitrides, since nitrogen has limited reaction with fresh metal in vacuum. In a particular embodiment, the nitrides deposition is carried out by the dual sputtering magnetron system assisted with a plasma source. A plasma discharge may also assist in the sputter deposition of metal oxides or nitrides with one or more metals (e.g. mixed oxides).

In a particular embodiment, the dielectric layer obtained in step d) comprises a dielectric material selected from the group consisting of AlₓO_{y}, SiₓO_{y}, TaₓO_{y}, TiₓO_{y}, ZrₓO_{y}, HfₓO_{y}, NbₓO_{y}, VₓO_{y}, CrₓO_{y}, CuₓO_{y}, COₓO_{y}, NiₓO_{y}, (NiCr)ₓO_{y}, MoₓO_{y}, WₓO_{y}, (TiB₂)ₓO_{y}, (TaB₂)ₓO_{y} (ZrB₂)ₓO_{y}, (HfB₂)ₓO_{y}, (VB₂)ₓO_{y}, AlₓN_{y}, SiₓN_{y}, TaₓN_{y}, TiₓN_{y} ZrₓN_{y}, HfₓN_{y}, NbₓN_{y}, VₓN_{y}, CrₓN_{y}, CuₓN_{y}, CoₓN_{y}, NiₓN_{y}, (NiCr)ₓN_{y}, MoₓN_{y}, WₓN_{y}, (TiB₂)ₓN_{y}, (TaB₂)ₓN_{y} (ZrB₂)ₓN_{y}, (HfB₂)ₓN_{y}, and (VB₂)ₓN_{y} or a combination or alloy thereof.

In a preferred embodiment, the dielectric layer obtained in step d) comprises an oxide or a nitride of a boride. Preferably, the dielectric layer obtained in step b) is selected from the group consisting of (TiB₂)ₓN_{y}, (TiB₂)ₓO_{y}, (TaB₂)ₓN_{y}, (TaB₂)ₓO_{y}, (ZrB₂)ₓN_{y}, (ZrB₂)ₓO_{y}, (HfB₂)ₓN_{y}, (HfB₂)ₓO_{y}, (NbB₂)ₓN_{y}, (NbB₂)ₓO_{y}, (VB₂)ₓN_{y} and (VB₂)ₓO_{y} or a combination or alloy thereof.

In another particular embodiment, the dielectric layer obtained in step d) comprises an oxide or a nitride of Al, Si, Ti, Zr, Hf, V, Nb, Ta, Cu, Cr or Ni.

In a particular embodiment the target material participating in the dual MF or pulsed DC sputtering for depositing dielectric material is the same material as in step b), resulting in the formation of a pure dielectric on the remaining conductive layer, if any.

In another particular embodiment, the target material participating in the dual MF or pulsed DC sputtering is a different material than in step b), resulting in the formation of a dielectric alloy and/or a stack of dielectrics on the remaining conductive layer, if any. Said dielectric alloy and/or a stack of dielectrics derives from the dielectric layer obtained from transforming the conductive layer and the dielectric material deposited in the dual MF or pulsed DC sputtering.

As set forth in step e), the method of the invention may be repeated as many times as desired so as to obtain at least one functional layer suitable for a multilayer solar selective coating. In a particular embodiment, the functional layer is intended to form part of a multilayer solar selective coating of a heat receiver tube. More particularly, the functional layer is or may form part of an absorber coating of cermet-like material, an anti-reflective coating or a diffusion barrier of dielectric material.

### Arrangement of a functional layer of cermet-like material (suitable for solar energy absorptive coating)

The method of the invention may be used to prepare a functional layer or coating of a material based on a periodic arrangement of ultra-thin layers that behaves similar to a cermet material. In particular, the cermet-like material is a periodic and alternate arrangement or stack of a conductive layer and a dielectric layer.

In a particular embodiment for the cermet-like material, the refractive index n is selected from the range between about 1.5 and about 4.0 and the extinction coefficient k is selected from the range between about 0.2 and about 3.0 in the wavelength range between about 350 nm and about 2500 nm, more particularly, the refractive index n is selected from the range between about 2.0 and about 3.5 and the extinction coefficient is selected from the range between about 0.5 and about 2.5.

In the cermet-like material the absorbing conductive layer and the transparent dielectric layer may be represented as (M/MₓO_{y})^{r} and (M/MₓN_{y})^{r} for the oxidized and nitrided layers respectively,
where:
- M is an absorbing conductive layer;
- MₓO_{y} is a transparent dielectric oxide layer;
- MₓN_{y} is a transparent dielectric nitride layer; and
- r is the dual layer (conductive-dielectric) repetition number.

Below are particular examples wherein the conductive layer deposited in step b) is partially transformed into a dielectric in step d) thereby obtaining a multilayer stack of alternate conductive and dielectric layers (cermet-like material) suitable as solar energy absorptive coating for a heat receiver tube: Al/AlₓO_{y}, Al/AlₓN_{y}, Ti/TiₓO_{y}, Ta/TaₓO_{y}, Cr/CrₓO_{y}, Ni/NiₓO_{y}, Cu/CuₓO_{y}, Co/CoₓO_{y}, Mo/MoₓO_{y}, W/WₓO_{y}, NiCr/(NiCᵣ)ₓO_{y}, TiB₂/(TiB₂)ₓO_{y}, TiB₂/(TiB₂)ₓN_{y}, TaB₂/(TaB₂)ₓO_{y}, TaB₂/(TaB₂)ₓN_{y}, ZrB₂/(ZrB₂)ₓO_{y}, ZrB₂/(ZrB₂)ₓN_{y}, HfB₂/(HfB₂)ₓO_{y}, HfB₂/(HfB₂)ₓN_{y}, VB₂/(VB₂)ₓO_{y}, VB₂/(VB₂)ₓN_{y}, or a combination of the same.

In another embodiment, two different conductive layers are deposited in step b) by using two different cathodes in the DC and / or MF sputtering. Using two conductive materials is especially advantageous when the first one has high affinity and could be completely oxidized/nitrided. In such a case, one can sputter on top of it a second conductive layer that will undergo transformation into dielectric and keep the first one as is. The basic configuration will then be: (M¹/M²ₓO_{y})^{r} and (M¹/M²ₓN_{y})^{r}, where:
- M¹ is the first conductive material;
- M² is the second conductive material that is completely transferred to oxide dielectric M²ₓO_{y} or to nitride dielectric M²ₓN_{y}; and
- r is the dual layer (conductive-dielectric) repetition number.

For example, Mo reacts easily with O₂. In order to have a stack of Mo/Al₂O₃, Mo and Al can be deposited in the deposition chamber and then oxidize the Al on the transformation chamber, without affecting the Mo.

Below are particular examples wherein two conductive layers are deposited in step b) and the second layer is transformed into a dielectric in step d) thereby obtaining a multilayer stack of alternate conductive and dielectric layers (cermet-like material) suitable as solar energy absorptive coating for a heat receiver tube, where M¹ is different than M²:
Mo/AlₓO_{y}, Mo/AlₓN_{y},
W/AlₓOy, W/AlₓN_{y},
TiB₂/ZrₓN_{y}, TiB₂/AlₓN_{y}, TiB₂/SiₓN_{y}, TiB₂/ZrₓO_{y}, TiB₂/AlₓO_{y}, TiB₂/SiₓO_{y}, TaB₂/ZrₓN_{y}, TaB₂/AlₓN_{y}, TaB₂/SiₓN_{y}, TaB₂/ZrₓO_{y}, TaB₂/AlₓO_{y}, TaB₂/SiₓO_{y}, ZrB₂/ZrₓN_{y}, ZrB₂/AlₓN_{y}, ZrB₂/SiₓN_{y}, ZrB₂/ZrₓO_{y}, ZrB₂/AlₓO_{y}, ZrB₂/SiₓO_{y}, HfB₂/ZrₓN_{y}, HfB₂/AlₓN_{y}, HfB₂/SᵢₓN_{y}, HfB₂/ZrₓO_{y}, HfB₂/AlₓO_{y}, HfB₂/SiₓO_{y}, VB₂/ZrₓN_{y}, VB₂/AlₓN_{y}, VB₂/SiₓN_{y}, VB₂/ZrₓO_{y}, VB₂/AlₓO_{y}, VB₂/SiₓO_{y}
or a combination of the same.

In another embodiment, the target material participating in the dual MF or pulsed DC sputtering is a different material than in step b), resulting in the formation of a dielectric alloy and/or a stack of dielectrics consisting of the dielectric layer obtained from transforming the conductive layer and the dielectric material deposited in the dual MF or pulsed DC sputtering. The basic configuration will then be: (M¹/M¹ₓO_{y}/M²ₓO_{y})^{r} and (M¹/M¹ₓN_{y}/M²ₓN_{y})^{r}, where:
- M¹ is the first conductive material, that is transferred to oxide dielectric M¹ₓO_{y} or to nitride dielectric M¹ₓN_{y};
- M² is the target material participating in step d); and
- r is the triple layer (conductive-dielectric-dielectric) repetition number.

Below are particular examples wherein the target material participating in step d) is different than the conductive material in step b) thereby obtaining a multilayer stack of a conductive layer and two different dielectric layers (cermet-like material) suitable as solar energy absorptive coating for a heat receiver tube:
TiB₂/(TiB₂)ₓN_{y}/ZrₓN_{y}, TiB₂/(TiB₂)ₓN/AlₓN_{y}, TiB₂/(TiB₂)ₓN_{y}/SiₓN_{y}, TiB₂/(TiB₂)ₓO_{y}/ZrₓO_{y}, TiB₂/(TiB₂)ₓO_{y}/AlₓO_{y}, TiB₂/(TiB₂)ₓO_{y}/SiₓO_{y}, TaB₂/(TaB₂)ₓN_{y}/ZrₓN_{y}, TaB₂/(TaB₂)ₓN_{y}/AlₓN_{y}, TaB₂/(TaB₂)ₓN_{y}/SiₓN_{y}, TaB₂/(TaB₂)ₓO_{y}/ZrₓO_{y}, TaB₂/(TaB₂)ₓO_{y}/AlₓO_{y}, TaB₂/(TaB₂)ₓO_{y}/SiₓO_{y}, ZrB₂/(ZrB₂)ₓN_{y}/ZrₓN_{y}, ZrB₂/(ZrB₂)ₓN_{y}/AlₓN_{y}, ZrB₂/(ZrB₂)ₓN_{y}/SiₓN_{y}, ZrB₂/(ZrB₂)ₓO_{y}/ZrₓO_{y}, ZrB₂/(ZrB₂)ₓO_{y}/AlₓO_{y}, ZrB₂/(ZrB₂)ₓO_{y}/SiₓO_{y}, HfB₂/(HfB₂)ₓN_{y}/ZrₓN_{y}, HfB₂/(HfB₂)ₓN_{y}/AlₓN_{y}, HfB₂/(HfB₂)ₓN_{y}/SiₓN_{y}, HfB₂/(HfB₂)ₓO_{y}/ZrₓO_{y}, HfB₂/(HfB2)ₓO_{y}/AlₓO_{y}, HfB₂/(HfB₂)ₓO_{y}/SiₓO_{y}, VB₂/(VB₂)ₓN_{y}/ZrₓN_{y}, VB₂/(VB₂)ₓN_{y}/AlₓN_{y}, VB₂/(VB₂)ₓN_{y}/SiₓN_{y}, VB₂/(VB₂)ₓO_{y}/ZrₓO_{y}, VB₂/(VB₂)ₓO_{y}/AlₓO_{y}, VB₂/(VB₂)ₓO_{y}/SiₓO_{y} or a combination of the same.

Additionally, the thicknesses of the layers are important for the optical characteristics of the individual layers and therefore important for the overall optical characteristics of the adsorptive coating.

The ratio between the conductive layer thickness (d₁) to the dielectric layer thickness (d₂) provides the filling factor (F.F.). The extinction coefficient, and in turn the absorbance, increases with the filing factor. According to a particular embodiment, the cermet-like material may comprise different regions in terms of metal content. For instance, the cermet-like material may comprise a first region having conductive layers thicker than the dielectric layers (d₁ > d₂) and a second region having conductive layers thinner than the dielectric layers (d₁ < d₂).

Another configuration is a cermet-like material having a graded distribution of conductive material content, beginning with a high ratio d₁/d₂ >1 and ending with ending with a low ratio d₁/d₂ <1.

Typically both the conductive layer thickness d₁ and the dielectric layer thickness d₂ independently range from about 0.5 nm to about 5 nm.

The total thickness of the cermet-like material normally ranges from about 10 nm to about 100 nm.

### Arrangement of a functional layer of dielectrics (suitable for anti-reflective coating or diffusion barrier)

Common methods for dielectric deposition have the following disadvantages:
- RF, MF or pulsed DC sputtering from a dielectric target show a low deposition rate;
- Reactive RF, MF or pulsed DC sputtering from a metallic target with reactive gas, show a very low deposition rate when operating in oxide mode, whereas with a transient mode achieve a higher deposition rate but are very difficult to control.

The method of the invention may be used to prepare a functional layer or coating of a transparent material by full oxidation or nitration of the conductive layers attached to the substrate in step b).

In order to achieve full oxidation or nitration, the assistance of plasma in the method of the invention may be necessary. The preparation of functional layers of oxide or nitride can be applied to any conductive material such as, Al, Si, Ti, Zr, Hf, V, Nb, Ta, Cu, Cr and Ni.

The deposition rate obtained with the dual mode method of the invention is higher than the one achieved with MF sputtering operating in reactive (oxide) mode. For instance, the maximum depositing rate of Al₂O₃ using 100kW MF power in oxide mode is only 1.5 nm/min while with dual mode method the maximum deposition rate may be 4.4 nm/min by using power of only 18kW. For TiO₂ the difference in deposition rate between dual and MF sputtering mode become much higher (0.3 nm/min compared to 4.4 nm/min).

By using Ti target in DC sputtering in metallic mode and Si in Dual MF Sputtering in oxide mode, it is possible, by applying appropriate power levels to achieve any mixture of (TiO₂)x (SiO₂)₁₋ₓ. The resulting compound may have almost continuous refractive index varying from 1.5 (for almost SiO₂) to 2.3 (for almost TiO₂). Any other different couple of metals can also be used in order to achieve the same formulation.

As used herein, the term "about" means a slight variation of the value specified, preferably within 10 percent of the value specified. Nevertheless, the term "about" can mean a higher tolerance of variation depending on for instance the experimental technique used. Said variations of a specified value are understood by the skilled person and are within the context of the present invention. Further, to provide a more concise description, some of the quantitative expressions given herein are not qualified with the term "about". It is understood that, whether the term "about" is used explicitly or not, every quantity given herein is meant to refer to the actual given value, and it is also meant to refer to the approximation to such given value that would reasonably be inferred based on the ordinary skill in the art, including equivalents and approximations due to the experimental and/or measurement conditions for such given value.

All the features described in this specification (including the claims, description and drawings) and/or all the steps of the described method can be combined in any combination, with the exception of combinations of such mutually exclusive features and/or steps.

The invention will be further illustrated by means of examples, which should not be interpreted as limiting the scope of the claims.

### EXAMPLES

### EXAMPLE 1: (Dielectric layer)

A functional layer of Al₂O₃ was prepared by the method of the invention.

A heat receiver tube loaded in a rotating carousel drum was introduced as substrate in the attaching chamber containing a DC sputtering equipped with an aluminum cathode positioned in front of the substrate at a distance of about 8 mm.

Argon flow of 1000 sccm was introduced using flow controllers. The argon flow was adjusted to maintain an equilibrium pressure with the pumping velocity. The working pressure in the attaching chamber (about 2.0x10⁻³ - 3.0x10⁻³ mBar) was measured by means of an Ion Gauge. An Al layer was deposited on the substrate in the attaching chamber applying 18 kW power.

The coated substrate was then transferred to the transforming chamber containing a Dual MF Sputtering having two aluminum cathodes wherein a power of 10 kW was applied and an oxygen flow of 400-800 sccm was introduced. The metal was thus oxidized by the presence of oxygen to produce Al₂O₃ at a rate of 4.4 nm/s, and also further Al₂O₃ was deposited by means of Dual MF Sputtering in the transforming chamber.

The process was repeated so that the outcome functional layer was an arrangement of Al₂O₃. Thus, using a low power level in the deposition chamber (18 kW) an homogeneous dielectric layer of Al₂O₃ was obtained with deposition rate of 4.4 nm/s.

The uniformity of the coating along the tube length, and the optical characteristics were measured by ellipsometry.

### EXAMPLE 2: (Dielectric layer)

A functional layer of SiO₂ was prepared by the method of the invention.

A heat receiver tube loaded in a rotating carousel drum was introduced as substrate in the attaching chamber containing a DC sputtering equipped with a silicon cathode positioned in front of the substrate at a distance of about 8 mm.

Argon flow of 1000 sccm was introduced using flow controllers. The argon flow was adjusted to maintain an equilibrium pressure with the pumping velocity. The working pressure in the attaching chamber (about 2.0x10⁻³ - 3.0x10⁻³ mBar) was measured by means of an Ion Gauge. A Si layer was deposited on the substrate in the deposition chamber applying a power of 28 kW.

The coated substrate was then transferred to the transforming chamber containing a Dual MF Sputtering having one or two Silicon cathodes wherein a power of 10 - 60 kW was applied and an oxygen flow of 400-800 sccm was introduced. The metal was thus oxidized by the presence of oxygen to produce SiO₂ at a deposition rate of 4.5 nm/s, and also further SiO₂ was deposited by means of Dual MF Sputtering in the transforming chamber.

The process was repeated so that the outcome functional layer was an arrangement of SiO₂. Thus, using a low power level in the attaching chamber (28 kW) an homogeneous dielectric layer of SiO₂ was obtained with deposition rate of 4.5 nm/s.

The uniformity of the coating along the tube length, and the optical characteristics were measured by ellipsometry.

### EXAMPLE 3: (Cermet-like layer)

A functional layer of (ZrB₂/AlN)^{r} was prepared by the method of the invention.

A heat receiver tube loaded in a rotating carousel drum was introduced as substrate in the attaching chamber containing a DC sputtering equipped with a ZrB₂ cathode and an aluminum cathode positioned in front of the substrate at a distance of about 8 mm.

Argon flow of 1000 sccm was introduced using flow controllers. The argon flow was adjusted to maintain an equilibrium pressure with the pumping velocity. The working pressure in the attaching chamber (about 2.0x10⁻³ - 3.0x10⁻³ mBar) was measured by means of an Ion Gauge. A ZrB₂ layer and an Al layer were deposited on the substrate in the deposition chamber.

The coated substrate was then transferred to the transforming chamber containing a Dual MF Sputtering having one or two aluminum cathodes wherein a power of 5 - 60 kW was applied (the power level was varied in order to obtain different coatings) and a nitrogen flow of 200-800 sccm was introduced. The Al layer was thus nitrided by the presence of nitrogen in the transforming chamber to form a dielectric layer of AIN.

The process was repeated so that the outcome functional layer was an arrangement of ZrB₂/AlN bilayers.

The uniformity of the coating along the tube length, and the optical characteristics were measured by ellipsometry.

### EXAMPLE 4: (Cermet-like layer)

A functional layer of (ZrB₂/ZrN)^{r} was prepared by the method of the invention.

A heat receiver tube loaded in a rotating carousel drum was introduced as substrate in the attaching chamber containing a DC sputtering equipped with a ZrB₂ cathode and a zirconium cathode positioned in front of the substrate at a distance of about 8 mm.

Argon flow of 1000 sccm was introduced using flow controllers. The argon flow was adjusted to maintain an equilibrium pressure with the pumping velocity. The working pressure in the attaching chamber (about 2.0x10⁻³ - 3.0x10⁻³ mBar) was measured by means of an Ion Gauge. A ZrB₂ layer and a Zr layer were deposited on the substrate in the deposition chamber.

The coated substrate was then transferred to the transforming chamber containing a Dual MF Sputtering having Zirconium cathodes wherein a power of 5 - 60 kW was applied and a nitrogen flow of 200-800 sccm was introduced. The Zr layer was thus nitrided by the presence of nitrogen in the transforming chamber to form a dielectric layer of ZrN.

The process was repeated so that the outcome functional layer was an arrangement of ZrB₂/ZrN bilayers.

The uniformity of the coating along the tube length, and the optical characteristics were measured by ellipsometry

## Claims

1. Method for the deposition of at least one functional layer suitable for a multilayer solar selective coating, said method comprising:
a) providing a substrate;
b) depositing conductive material on said substrate in a deposition chamber (1) to obtain a substrate coated with at least one conductive layer;
**characterized in that** the method further comprises:
c) transferring the coated substrate obtained in b) to a transformation chamber (2) ;
d) transforming the coating of the substrate by introducing a reactive gas into the transformation chamber (2) so that at least an outer conductive layer of the at least one conductive layer is partially or totally transformed into at least one dielectric layer; and
e) optionally, transferring the substrate obtained in d) to the deposition chamber (1) and repeating the method from step b) for a number of times.

2. Method according to claim 1, wherein the substrate is a heat receiver tube, optionally coated with at least a previous coating.

3. Method according to claim 2, wherein the method is carried out for a batch of tubes that are loaded onto a rotating carousel drum (5) so that the tubes travel from the deposition chamber (1) to the transforming chamber (2) and vice versa for a number of times, while the loaded tubes rotate in turn around their own axis in planetary movement.

4. Method according to any one of the preceding claims wherein the deposition chamber (1) and the transformation chamber (2) are separated with shields
and/or
wherein vacuum is applied by means of vacuum pumps included within separation chambers (3, 4) and placed between the deposition chamber (1) and the transformation chamber (2).

5. Method according to any one of the preceding claims wherein the deposition of the conductive material in step b) is carried out by means of DC sputtering, MF pulsed DC sputtering or dual MF sputtering.

6. Method according to any one of the claims 1 to 5, wherein the conductive material is selected from the group consisting of aluminum (Al), chrome (Cr), titanium (Ti), niobium (Nb), zirconium (Zr), tantalum (Ta), nickel (Ni), copper (Cu), cobalt (Co), hafnium (Hf), vanadium (V), molybdenum (Mo), tungsten (W), Silicon (Si), Nichrome (NiCr), Titaniumboride (TiB₂), Tantalumboride (TaB₂), Zirconiumboride (ZrB₂), Hafiniumboride (HfB₂), Niobiumboride (NbB₂) and Vanadiumboride (VB₂) or a combination or alloy thereof.

7. Method according to any one of the preceding claims, wherein the dielectric layer obtained in step d) comprises a dielectric material selected from the group consisting of: AlₓO_{y}, SiₓO_{y}, TaₓO_{y}, TiₓO_{y}, ZrₓO_{y}, HfₓO_{y}, NbₓO_{y}, VₓO_{y}, CrₓO_{y}, CuₓO_{y}, COₓO_{y}, NiₓO_{y}, (NiCr)ₓO_{y}, MoₓO_{y}, WₓO_{y}, (TiB₂)ₓO_{y}, (TaB₂)ₓO_{y}, (ZrB₂)ₓO_{y}, (HfB₂)ₓO_{y}, (NbB₂)ₓO_{y}, (VB₂)ₓO_{y}, AlₓN_{y}, SiₓN_{y}, TaₓN_{y}, TiₓN_{y}, ZrₓN_{y}, HfₓN_{y}, NbₓN_{y}, VₓN_{y}, CrₓN_{y}, CuₓN_{y}, CoₓN_{y}, NiₓN_{y}, (NiCr)ₓN_{y}, MoₓN_{y}, WₓN_{y}, (TiB₂)ₓN_{y}, (TaB₂)ₓN_{y}, (ZrB₂)ₓN_{y}, (HfB₂)ₓN_{y}, (NbB₂)ₓN_{y} and (VB₂)ₓN_{y} or a combination or alloy thereof.

8. Method according to any one of the preceding claims, wherein step d) further comprises, after or simultaneously with the transformation, the deposition of dielectric material by means of dual MF sputtering or pulsed DC sputtering.

9. Method according to claim 8, wherein the target material participating in the dual MF or pulsed DC sputtering is:
- the same material as in step b), resulting in the formation of a pure dielectric on the remaining conductive layer, if any, of the at least one conductive layer; or
- a different material than in step b), resulting in the formation of a dielectric alloy and/or a stack of dielectrics on the remaining conductive layer, if any, of the at least one conductive layer.

10. Method according to any one of the preceding claims, wherein the at least one conductive layer deposited in step b) is totally transformed into a dielectric layer in step d) thereby obtaining an anti-reflective coating or a diffusion barrier for a heat receiver tube.

11. Method according to any one of claims 1 to 8, wherein the at least one conductive layer deposited in step b) is partially transformed into a dielectric in step d) thereby obtaining a multilayer stack of alternate conductive and dielectric layers suitable as solar energy absorptive coating for a heat receiver tube.

12. Method according to claim 11, wherein the multilayer stack is selected from the group consisting of: Al/AlₓO_{y}, Al/AlₓN_{y}, Ti/TiₓO_{y}, Ta/TaₓO_{y}, Cr/CrₓO_{y}, Ni/NiₓO_{y}, Cu/CuₓO_{y}, Co/CoₓO_{y}, Mo/MoₓO_{y}, W/WₓO_{y}, NiCr/(NiCᵣ)ₓO_{y}, TiB₂/(TiB₂)ₓN_{y}, TiB_{2/}(TiB₂)ₓO_{y}, TaB_{2/}(TₐB₂)ₓN_{y}, TaB₂/(TaB₂)ₓO_{y}, ZrB₂/(ZrB₂)ₓN_{y}, ZrB₂/(ZrB₂)ₓO_{y}, HfB₂/(HfB₂)ₓN_{y}, HfB₂/(HfB₂)ₓO_{y}, VB₂/(VB₂)ₓN_{y}, and VB₂/(VB₂)ₓO_{y} or a combination of the same.

13. Method according to any one of claims 1 to 8, wherein two different conductive materials are deposited in step b) by using two different cathodes in the sputtering and a second conductive layer of the at least one conductive layer is totally transformed into a dielectric in step d), thereby obtaining a multilayer stack of alternate conductive and dielectric layers suitable as solar energy absorptive coating for a heat receiver tube.

14. Method according to claim 13, wherein the multilayer stack is selected from the group consisting of:
Mo/AlₓO_{y}, Mo/AlₓN_{y},
W/AlₓOy, W/AlₓNy
TiB₂/ZrₓN_{y}, TiB₂/AlₓN_{y}, TiB₂/SiₓN_{y}, TiB₂/ZrₓO_{y}, TiB₂/AlₓO_{y}, TiB₂/SiₓO_{y}, TaB₂/ZrₓN_{y}, TaB₂/AlₓN_{y}, TaB₂/SiₓN_{y}, TaB₂/ZrₓO_{y}, TaB₂/AlₓO_{y}, TₐB_{2/}SiₓO_{y} ZrB₂/ZrₓN_{y}, ZrB₂/AlₓN_{y}, ZrB₂/SiₓN_{y}, ZrB₂/AlₓO_{y}, ZrB₂/SiₓO_{y}, HfB₂/ZrₓN_{y}, HfB₂/AlₓN_{y}, HfB₂/SiₓN_{y}, HfB₂/ZrₓO_{y}, HfB₂/AlₓO_{y}, HfB₂/SiₓO_{y}, VB₂/ZrₓN_{y}, VB₂/AlₓN_{y}, VB₂/SiₓN_{y}, VB₂/ZrₓO_{y}, VB₂/AlₓOy, and VB₂/SiₓO_{y}
or a combination of the same.

15. Method according to claim 9, wherein a stack of dielectrics is formed on the remaining conductive layer of the at least one conductive layer, thereby obtaining a multilayer stack selected from the group consisting of:
TiB₂/(TiB₂)ₓN_{y}/ZrₓN_{y}, TiB₂/(TiB₂)ₓN_{y}/AlₓNy, TiB₂/(TiB₂)ₓN_{y}/SiₓN_{y}, TiB₂/(TiB₂)ₓO_{y}/ZrₓO_{y}, TiB₂/(TiB₂)ₓO_{y}/AlₓOy, TiB₂/(TiB₂)ₓO_{y}/SiₓOy TaB₂/(TaB₂)ₓN_{y}/ZrₓN_{y}, TₐB₂/(TₐB₂)ₓN_{y}/AlₓN_{y}, TaB₂/(TaB₂)ₓN_{y}/SiₓN_{y}, TaB₂/(TaB₂)ₓO_{y}/ZrₓO_{y}, TₐB₂/(TₐB₂)ₓO_{y}/AlₓO_{y}, TₐB₂/(TₐB₂)ₓO_{y}/SiₓO_{y} ZrB₂/(ZrB₂)ₓN_{y}/ZrₓN_{y}, ZrB₂/(ZrB₂)ₓN_{y}/AlₓN_{y}, ZrB₂/(ZrB₂)ₓN_{y}/SiₓN_{y}, ZrB₂/(ZrB₂)ₓO_{y}/ZrₓO_{y}, ZrB_{2/}(ZrB₂)ₓO_{y}/AlₓO_{y}, ZrB₂/(ZrB₂)ₓO_{y}/SiₓO_{y}, HfB₂/(HfB₂)ₓN_{y}/ZrₓN_{y}, HfB₂/(HfB₂)ₓN_{y}/AlₓN_{y}, HfB₂/(HfB₂)ₓN_{y}/SiₓN_{y}, HfB₂/(HfB₂)ₓO_{y}/ZrₓO_{y}, HfB₂/(HfB₂)ₓO_{y}/AlₓO_{y}, HfB₂/(HfB₂)ₓO_{y}/SiₓO_{y}, VB₂/(VB₂)ₓN_{y}/ZrₓN_{y}, VB₂/(VB₂)ₓN_{y}/AlₓN_{y}, VB₂/(VB₂)ₓN_{y}/SiₓN_{y}, VB₂/(VB₂)ₓO_{y}/ZrₓO_{y}, VB₂/(VB₂)ₓO_{y}/AlₓO_{y}, and VB₂/(VB₂)ₓO_{y}/SiₓO_{y}
or a combination of the same.

## Patentansprüche

1. Verfahren zum Abscheiden von mindestens einer Funktionsschicht, welche für eine mehrschichtige solarselektive Beschichtung geeignet ist, wobei das Verfahren umfasst:
a) Bereitstellen eines Trägermaterials;
b) Abscheiden von leitfähigem Material auf dem Trägermaterial in einer Abscheidekammer (1), um ein mit mindestens einer leitfähigen Schicht beschichtetes Trägermaterial zu erhalten; **dadurch gekennzeichnet, dass** das Verfahren ferner umfasst:
c) Überführen des in b) erhaltenen beschichteten Trägermaterials in eine Transformationskammer (2);
d) Umwandeln der Beschichtung des Trägermaterials durch Einbringen eines reaktiven Gases in die Transformationskammer (2), so dass mindestens eine äußere leitfähige Schicht der mindestens einen leitfähigen Schicht teilweise oder vollständig in mindestens eine dielektrische Schicht umgewandelt wird;
und
e) gegebenenfalls, Überführen des in d) erhaltenen Trägermaterials in die Abscheidekammer (1) und mehrmaliges Wiederholen des Verfahrens ab Schritt b).

2. Verfahren gemäß Anspruch 1, wobei das Trägermaterial ein Wärmeempfängerrohr ist, welches gegebenenfalls mit mindestens einer vorherigen Beschichtung beschichtet ist.

3. Verfahren gemäß Anspruch 2, wobei das Verfahren für eine Charge an Rohren durchgeführt wird, welche auf eine drehbare Karusselltrommel (5) geladen sind, so dass sich die Rohre mehrmals von der Abscheidekammer (1) zu der Transformationskammer (2) und umgekehrt bewegen, während sich die geladenen Rohre in planetarer Bewegung um ihre eigene Achse drehen.

4. Verfahren gemäß einem der vorhergehenden Ansprüche, wobei die Abscheidekammer (1) und die Transformationskammer (2) mit Abschirmungen abgetrennt sind und/oder wobei Vakuum mittels Vakuumpumpen, welche in den Abtrennkammern (3, 4) enthalten sind und zwischen der Abscheidekammer (1) und der Transformationskammer (2) angeordnet sind, angelegt wird.

5. Verfahren gemäß einem der vorhergehenden Ansprüche, wobei das Abscheiden des leitfähigen Materials in Schritt b) mittels Gleichstrom-Sputtern, MFgepulstem Gleichstrom-Sputtern oder dualem MF-Sputtern durchgeführt wird.

6. Verfahren gemäß einem der Ansprüche 1 bis 5, wobei das leitfähige Material ausgewählt ist aus der Gruppe bestehend aus Aluminium (A1), Chrom (Cr), Titan (Ti), Niobium (Nb), Zirkonium (Zr), Tantal (Ta), Nickel (Ni), Kupfer (Cu), Cobalt (Co), Hafnium (Hf), Vanadium (V), Molybdän (Mo), Wolfram (W), Silizium (Si), Nickelchrom (NiCr), Titanborid (TiB₂), Tantalborid (TaB₂), Zirkoniumborid (ZrB₂), Hafniumborid (HfB₂), Niobborid (NbB₂) und Vanadiumborid (VB₂) oder einer Kombination oder Legierung davon.

7. Verfahren gemäß einem der vorhergehenden Ansprüche, wobei die in Schritt d) erhaltene dielektrische Schicht ein dielektrisches Material umfasst, ausgewählt aus der Gruppe bestehend aus: AlₓO_{y}, SiₓO_{y}, TaₓO_{y}, TiₓO_{y}, ZrₓO_{y}, HfₓO_{y}, NbₓO_{y}, VₓO_{y}, CrₓO_{y}, CuₓO_{y}, COₓO_{y}, NiₓO_{y}, (NiCr)ₓO_{y}, MoₓO_{y}, WₓO_{y}, (TiB₂)ₓO_{y}, (TaB₂)ₓO_{y}, (ZrB₂)ₓO_{y}, (HfB₂)ₓO_{y}, (NbB₂)ₓO_{y}, (VB₂)ₓO_{y}, AlₓN_{y}, SiₓN_{y}, TaₓN_{y}, TiₓN_{y}, ZrₓN_{y}, HfₓN_{y}, NbₓN_{y}, VₓN_{y}, CrₓN_{y}, CuₓN_{y}, CoₓN_{y}, NiₓN_{y}, (NiCr)ₓN_{y}, MoₓN_{y}, WₓN_{y}, (TiB₂)ₓN_{y}, (TaB₂)ₓN_{y}, (ZrB₂)ₓN_{y}, (HfB₂)ₓN_{y}, (NbB₂)ₓN_{y} und (VB₂)ₓN_{y} oder einer Kombination oder Legierung davon.

8. Verfahren gemäß einem der vorhergehenden Ansprüche, wobei Schritt d) ferner umfasst, nach der oder gleichzeitig mit der Umwandlung, das Abscheiden von dielektrischem Material mittels dualem MF-Sputtern oder gepulstem Gleichstrom-Sputtern.

9. Verfahren gemäß Anspruch 8, wobei das Targetmaterial, welches an dem dualen MF- oder gepulstem Gleichstrom-Sputtern beteiligt ist, folgendes ist:
- das gleiche Material wie in Schritt b), was zur Bildung eines reinen Dielektrikums auf der verbleibenden leitfähigen Schicht, falls vorhanden, der mindestens einen leitfähigen Schicht führt;
oder
- ein anderes Material als in Schritt b), was zur Bildung einer dielektrischen Legierung und/oder einem Stapel von Dielektrika auf der verbleibenden leitfähigen Schicht, falls vorhanden, der mindestens einen leitfähigen Schicht führt.

10. Verfahren gemäß einem der vorhergehenden Ansprüche, wobei die mindestens eine in Schritt b) abgeschiedene leitfähige Schicht vollständig in eine dielektrische Schicht in Schritt d) umgewandelt wird, wodurch eine Antireflex-Beschichtung oder eine Diffusionssperre für ein Wärmeempfängerrohr erhalten wird.

11. Verfahren gemäß einem der Ansprüche 1 bis 8, wobei die mindestens eine in Schritt b) abgeschiedene leitfähige Schicht teilweise in ein Dielektrikum in Schritt d) umgewandelt wird, wodurch ein mehrschichtiger Stapel von abwechselnd leitenden und dielektrischen Schichten erhalten wird, welche als Solarenergie absorbierende Beschichtung für ein Wärmeempfängerrohr geeignet sind.

12. Verfahren gemäß Anspruch 11, wobei der mehrschichtige Stapel ausgewählt ist aus der Gruppe bestehend aus: Al/AlₓO_{y}, Al/AlₓN_{y}, Ti/TiₓO_{y}, Ta/TaₓO_{y}, Cr/CrₓO_{y}, Ni/NiₓO_{y}, Cu/CuₓO_{y}, Co/CoₓO_{y}, Mo/MoₓO_{y}, W/WₓO_{y}, NiCr/(NiCᵣ)ₓO_{y}, TiB₂/(TiB₂)ₓN_{y}, TiB₂/(TiB₂)ₓO_{y}, TaB₂/(TaB₂)ₓN_{y}, TaB₂/(TaB₂)ₓO_{y}, ZrB₂/(ZrB₂)ₓN_{y}, ZrB₂/(ZrB₂)ₓO_{y}, HfB₂/(HfB₂)ₓN_{y}, HfB₂/(HfB₂)ₓO_{y}, VB₂/(VB₂)ₓN_{y} und VB₂/(VB₂)ₓO_{y} oder einer Kombination derselben.

13. Verfahren gemäß einem der Ansprüche 1 bis 8, wobei zwei verschiedene leitfähige Materialien in Schritt b) unter Verwendung von zwei verschiedenen Kathoden beim Sputtern abgeschieden werden und eine zweite leitfähige Schicht der mindestens einen leitfähigen Schicht in Schritt d) vollständig in ein Dielektrikum umgewandelt wird, wodurch ein mehrschichtiger Stapel von abwechselnd leitenden und dielektrischen Schichten erhalten wird, welche als Solarenergie absorbierende Beschichtung für ein Wärmeempfängerrohr geeignet sind.

14. Verfahren gemäß Anspruch 13, wobei der mehrschichtige Stapel ausgewählt ist aus der Gruppe bestehend aus:
Mo/AlₓO_{y}, Mo/AlₓN_{y},
W/AlₓOy, W/AlₓN_{y}
TiB₂/ZrₓN_{y}, TiB₂/AlₓN_{y}, TiB₂/SiₓN_{y}, TiB₂/ZrₓO_{y}, TiB₂/AlₓO_{y}, TiB₂/SiₓO_{y}, TaB₂/ZrₓN_{y}, TaB₂/AlₓN_{y}, TaB₂/SiₓN_{y}, TaB₂/ZrₓO_{y}, TaB₂/AlₓO_{y}, TaB₂/SiₓO_{y}, ZrB₂/ZrₓN_{y}, ZrB₂/AlₓN_{y}, ZrB₂/SiₓN_{y}, ZrB₂/AlₓO_{y}, ZrB₂/SiₓO_{y}, HfB₂/ZrₓN_{y}, HfB₂/AlₓN_{y}, HfB₂/SiₓN_{y}, HfB₂/ZrₓO_{y}, HfB₂/AlₓO_{y}, HfB₂/SiₓO_{y}, VB₂/ZrₓN_{y}, VB₂/AlₓN_{y}, VB₂/SiₓN_{y}, VB₂/ZrₓO_{y}, VB₂/AlₓOy und VB₂/SiₓO_{y}
oder einer Kombination derselben.

15. Verfahren gemäß Anspruch 9, wobei ein Stapel an Dielektrika auf der verbleibenden leitfähigen Schicht der mindestens einen leitfähigen Schicht gebildet wird, wodurch ein mehrschichtiger Stapel erhalten wird, ausgewählt aus der Gruppe bestehend aus:
TiB₂/(TiB₂)ₓN_{y}/ZrₓN_{y}, TiB₂/(TiB₂)ₓN_{y}/AlₓNy, TiB₂/(TiB₂)ₓN_{y}/SiₓN_{y}, TiB₂/(TiB₂)ₓO_{y}/ZrₓO_{y}, TiB₂/(TiB₂)ₓO_{y}/AlₓO_{y}, TiB₂/(TiB₂)ₓO_{y}/SiₓO_{y}, TaB₂/(TaB₂)ₓN_{y}/ZrₓN_{y}, TaB₂/(TaB₂)ₓN_{y}/AlₓN_{y}, TaB₂/(TaB₂)ₓN_{y}/SiₓN_{y}, TaB₂/(TaB₂)ₓO_{y}/ZrₓO_{y}, TaB₂/(TaB₂)ₓO_{y}/AlₓO_{y}, TaB₂/(TaB₂)ₓO_{y}/SiₓO_{y}, ZrB₂/(ZrB₂)ₓN_{y}/ZrₓN_{y}, ZrB₂/(ZrB₂)ₓN_{y}/AlₓN_{y}, ZrB₂/(ZrB₂)ₓN_{y}/SiₓN_{y}, ZrB₂/(ZrB₂)ₓO_{y}/ZrₓO_{y}, ZrB₂/(ZrB₂)ₓO_{y}/AlₓO_{y}, ZrB₂/(ZrB₂)ₓO_{y}/SiₓO_{y}, HfB₂/(HfB₂)ₓN_{y}/ZrₓN_{y}, HfB₂/(HfB₂)ₓN_{y}/AlₓN_{y}, HfB₂/(HfB₂)ₓN_{y}/SiₓN_{y}, HfB₂/(HfB₂)ₓO_{y}/ZrₓO_{y}, HfB₂/(HfB₂)ₓO_{y}/AlₓO_{y}, HfB₂/(HfB₂)ₓO_{y}/SiₓO_{y}, VB₂/(VB₂)ₓN_{y}/ZrₓN_{y}, VB₂/(VB₂)ₓN_{y}/AlₓN_{y}, VB₂/(VB₂)ₓN_{y}/SiₓN_{y}, VB₂/(VB₂)ₓO_{y}/ZrₓO_{y}, VB₂/(VB₂)ₓO_{y}/AlₓO_{y} und VB₂/(VB₂)ₓO_{y}/SiₓO_{y},
oder einer Kombination derselben.

## Revendications

1. Procédé de dépôt d'au moins une couche fonctionnelle appropriée pour un revêtement multicouche sélectif solaire, ledit procédé comprenant :
a) le fait d'aménager un substrat ;
b) le fait de déposer du matériau conducteur sur ledit substrat dans une chambre de dépôt (1) pour obtenir un substrat revêtu d'au moins une couche conductrice ;
**caractérisé en ce que** le procédé comprend en outre :
c) le fait de transférer le substrat revêtu obtenu en b) dans une chambre de transformation (2) ;
d) le fait de transformer le revêtement du substrat en introduisant un gaz réactif dans la chambre de transformation (2) de sorte qu'au moins une couche conductrice extérieure de ladite au moins une couche conductrice soit partiellement ou totalement transformée en au moins une couche diélectrique ; et
e) optionnellement, le fait de transférer le substrat obtenu en d) dans la chambre de dépôt (1) et de répéter le procédé à partir de l'étape b) un certain nombre de fois.

2. Procédé selon la revendication 1, dans lequel le substrat est un tube récepteur de chaleur, optionnellement revêtu d'au moins un revêtement antérieur.

3. Procédé selon la revendication 2, dans lequel le procédé est mis en oeuvre pour un lot de tubes qui sont chargés sur un tambour carrousel rotatif (5) de sorte que les tubes se déplacent un certain nombre de fois de la chambre de dépôt (1) à la chambre de transformation (2) et vice versa, alors que les tubes chargés tournent autour de leur propre axe selon un mouvement planétaire.

4. Procédé selon l'une quelconque des revendications précédentes, dans lequel la chambre de dépôt (1) et la chambre de transformation (2) sont séparées par des écrans et/ou
dans lequel un vide est appliqué au moyen de pompes à vide incluses dans des chambres de séparation (3, 4) et placées entre la chambre de dépôt (1) et la chambre de transformation (2).

5. Procédé selon l'une quelconque des revendications précédentes, dans lequel le dépôt du matériau conducteur dans l'étape b) est effectué au moyen d'une pulvérisation en courant continu, d'une pulvérisation pulsée en courant continu à MF ou d'une double pulvérisation à MF.

6. Procédé selon l'une quelconque des revendications 1 à 5, dans lequel le matériau conducteur est choisi dans le groupe consistant en aluminium (Al), chrome (Cr), titane (Ti), niobium (Nb), zirconium (Zr), tantale (Ta), nickel (Ni), cuivre (Cu), cobalt (Co), hafnium (Hf), vanadium (V), molybdène (Mo), tungstène (W), silicium (Si), nichrome (NiCr), borure de titane (TiB₂), borure de tantale (TaB₂), borure de zirconium (ZrB₂), borure de hafnium (HfB₂), borure de niobium (NbB₂) et borure de vanadium (VB₂) ou une combinaison ou un alliage de ceux-ci.

7. Procédé selon l'une quelconque des revendications précédentes, dans lequel la couche diélectrique obtenue à l'étape d) comprend un matériau diélectrique choisi dans le groupe constitué par : AlₓO_{y}, SiₓO_{y}, TaₓO_{y}, TiₓO_{y}, ZrₓO_{y}, HfₓO_{y}, NbₓO_{y}, VₓO_{y}, CrₓO_{y}, CuₓO_{y}, COₓO_{y}, NiₓO_{y}, (NiCr)ₓO_{y}, MoₓO_{y}, WₓO_{y}, (TiB₂)ₓO_{y}, (TaB₂)ₓO_{y}, (ZrB₂)ₓO_{y}, (HfB₂)ₓO_{y}, (NbB₂)ₓO_{y}, (VB₂)ₓO_{y}, AlₓN_{y}, SiₓN_{y}, TaₓN_{y}, TiₓN_{y}, ZrₓN_{y}, HfₓN_{y}, NbₓN_{y}, VₓN_{y}, CrₓN_{y}, CuₓN_{y}, CoₓN_{y}, NiₓN_{y}, (NiCr)ₓN_{y}, MoₓN_{y}, WₓN_{y}, (TiB₂)ₓN_{y}, (TaB₂)ₓN_{y}, (ZrB₂)ₓN_{y}, (HfB₂)ₓN_{y}, (NbB₂)ₓN_{y} et (VB₂)ₓN_{y} ou une combinaison ou un alliage de ceux-ci.

8. Procédé selon l'une quelconque des revendications précédentes, dans lequel l'étape d) comprend en outre, après ou simultanément avec la transformation, le dépôt de matériau diélectrique au moyen d'une double pulvérisation à MF ou d'une pulvérisation pulsée en courant continu.

9. Procédé selon la revendication 8, dans lequel le matériau cible participant à la pulvérisation pulsée en courant continu ou à la pulvérisation double à MF est :
- le même matériau que dans l'étape b), aboutissant à la formation d'un diélectrique pur sur la couche conductrice restante, s'il y en a une, de ladite au moins une couche conductrice ; ou
- un matériau différent de celui de l'étape b), aboutissant à la formation d'un alliage diélectrique et/ou d'une pile de diélectriques sur la couche conductrice restante, s'il y en a une, de ladite au moins une couche conductrice.

10. Procédé selon l'une quelconque des revendications précédentes, dans lequel ladite au moins une couche conductrice déposée à l'étape b) est totalement transformée en une couche diélectrique à l'étape d), de sorte qu'il est ainsi obtenu un revêtement antireflet ou une barrière de diffusion pour un tube récepteur de chaleur.

11. Procédé selon l'une quelconque des revendications 1 à 8, dans lequel ladite au moins une couche conductrice déposée à l'étape b) est partiellement transformée en diélectrique à l'étape d) de sorte qu'il est ainsi obtenu une pile multicouche de couches conductrices et diélectriques alternées convenant en tant que revêtement absorbant l'énergie solaire pour un tube récepteur de chaleur.

12. Procédé selon la revendication 11, dans lequel la pile multicouches est choisie dans le groupe constitué de : Al/AlₓO_{y}, Al/AlₓN_{y}, Ti/TiₓO_{y}, Ta/TaₓO_{y}, Cr/CrₓO_{y}, Ni/NiₓO_{y}, Cu/CuₓO_{y}, Co/CoₓO_{y}, Mo/MoₓO_{y}, W/WₓO_{y}, NiCr/(NiCᵣ)ₓO_{y}, TiB₂/(TiB₂)ₓN_{y}, TiB₂/(TiB₂)ₓO_{y}, TaB₂/(TaB₂)ₓN_{y}, TaB₂/(TaB₂)ₓO_{y}, ZrB₂/(ZrB₂)ₓN_{y}, ZrB₂/(ZrB₂)ₓO_{y}, HfB₂/(HfB₂)ₓN_{y}, HfB₂/(HfB₂)ₓO_{y}, VB₂/(VB₂)ₓN_{y} et VB₂/(VB₂)ₓO_{y} ou une combinaison de ceux-ci.

13. Procédé selon l'une quelconque des revendications 1 à 8, dans lequel deux matériaux conducteurs différents sont déposés dans l'étape b) en utilisant deux cathodes différentes au cours de la pulvérisation et une deuxième couche conductrice de ladite au moins une couche conductrice est totalement transformée en un diélectrique à l'étape d), de sorte qu'il est ainsi obtenu une pile multicouche de couches conductrices et diélectriques alternées appropriées en tant que revêtement pour absorber l'énergie solaire dans un tube récepteur de chaleur.

14. Procédé selon la revendication 13, dans lequel la pile multicouche est choisie dans le groupe constitué de :
Mo/AlₓO_{y}, Mo/AlₓN_{y},
W/AlₓOy, W/AlₓN_{y}
TiB₂/ZrₓN_{y}, TiB₂/AlₓN_{y}, TiB₂/SiₓN_{y}, TiB₂/ZrₓO_{y}, TiB₂/AlₓO_{y}, TiB₂/SiₓO_{y}, TaB₂/ZrₓN_{y}, TaB₂/AlₓN_{y}, TaB₂/SiₓN_{y}, TaB₂/ZrₓO_{y}, TaB₂/AlₓO_{y}, TaB₂/SiₓO_{y} ZrB₂/ZrₓN_{y}, ZrB₂/AlₓN_{y}, ZrB₂/SiₓN_{y}, ZrB₂/AlₓO_{y}, ZrB₂/SiₓO_{y}, HfB₂/ZrₓN_{y}, HfB₂/AlₓN_{y}, HfB₂/SiₓN_{y}, HfB₂/ZrₓO_{y}, HfB₂/AlₓO_{y}, HfB₂/SiₓO_{y}, VB₂/ZrₓN_{y}, VB₂/AlₓN_{y}, VB₂/SiₓN_{y}, VB₂/ZrₓO_{y}, VB₂/AlₓO_{y} et VB₂/SiₓO_{y}
ou une combinaison de ceux-ci.

15. Procédé selon la revendication 9, dans lequel une pile de diélectriques est formée sur la couche conductrice restante de ladite au moins une couche conductrice, obtenant ainsi une pile multicouche choisie dans le groupe constitué de :
TiB₂/(TiB₂)ₓN_{y}/ZrₓN_{y}, TiB₂/(TiB₂)ₓN_{y}/AlₓNy, TiB₂/(TiB₂)ₓN_{y}/SiₓN_{y}, TiB₂/(TiB₂)ₓO_{y}/ZrₓO_{y}, TiB₂/(TiB₂)ₓO/AlₓO_{y}, TiB₂/(TiB₂)ₓO_{y}/SiₓO_{y} TaB₂/(TaB₂)ₓN_{y}/ZrₓN_{y}, TaB₂/(TaB₂)ₓN_{y}/AlₓN_{y}, TaB₂/(TaB₂)ₓN_{y}/SiₓN_{y}, TaB₂/(TaB₂)ₓO_{y}/ZrₓO_{y}, TaB₂/(TaB₂)ₓO_{y}/AlₓO_{y}, TaB₂/(TaB₂)ₓO_{y}/SiₓO_{y} ZrB₂/(ZrB₂)ₓN_{y}/ZrₓN_{y}, ZrB₂/(ZrB₂)ₓN_{y}/AlₓN_{y}, ZrB₂/(ZrB₂)ₓN_{y}/SiₓN_{y}, ZrB₂/(ZrB₂)ₓO_{y}/ZrₓO_{y}, ZrB₂/(ZrB₂)ₓO_{y}/AlₓO_{y}, ZrB₂/(ZrB₂)ₓO_{y}/SiₓO_{y}, HfB₂/(HfB₂)ₓN_{y}/ZrₓN_{y}, HfB₂/(HfB₂)ₓN_{y}/AlₓN_{y}, HfB₂/(HfB₂)ₓN_{y}/SiₓN_{y}, HfB₂/(HfB₂)ₓO_{y}/ZrₓO_{y}, HfB₂/(HfB₂)ₓO_{y}/AlₓO_{y}, HfB₂/(HfB₂)ₓO_{y}/SiₓO_{y}, VB₂/(VB₂)ₓN_{y}/ZrₓN_{y}, VB₂/(VB₂)ₓN_{y}/AlₓN_{y}, VB₂/(VB₂)ₓN_{y}/SiₓN_{y}, VB₂/(VB₂)ₓO_{y}/ZrₓO_{y}, VB₂/(VB₂)ₓO_{y}/AlₓO_{y}, et VB₂/(VB₂)ₓO_{y}/SiₓO_{y}
ou une combinaison de ceux-ci.
